# EUROPEAN PATENT SPECIFICATION

(11) **EP 0 603 391 B1**
(45) Date of publication and mention of the grant of the patent: **23.07.1997**
(21) Application number: 92909800.2
(22) Date of filing: 15.05.1992
(51) Int. Cl.: F27B 17/00, C30B 31/12

(54) **VERTICAL HEAT TREATMENT APPARATUS AND HEAT INSULATING MATERIAL**
VERTIKALE WÄRMEBEHANDLUNGSVORRICHTUNG UND WÄRMEISOLATIONSMATERIAL
APPAREIL DE TRAITEMENT THERMIQUE A DISPOSITION VERTICALE ET MATERIAU THERMO-ISOLANT

(43) Date of publication of application: 29.06.1994
(73) Proprietor: SHIN-ETSU QUARTZ PRODUCTS CO., LTD., Shinjuku-ku, Tokyo (JP)
(72) Inventor: OKOSHI, Shinichi, Takefu Works Shin-Etsu, Takefu-shi, Fukui-ken 915 (JP); KIMURA, Hiroyuki, Takefu Works Shin-Etsu, Takefu-shi, Fukui-ken 915 (JP)
(74) Representative: Strehl Schübel-Hopf Groening & Partner
(86) International application number: PCT/JP92/00627
(87) International publication number: WO 93/23713

(56) References cited:
- US-A- 4 943 235

## Description

### Field of the Invention

The present invention relates to a vertical heat-treating apparatus constructed so that a vertical holder which is constructed so as to vertically laminate-dispose plate-shaped members (hereinafter referred to as substrates), glass substrate or the like such as a semiconductor wafer or liquid crystal, can be located on a heat insulator.

### Background of the invention

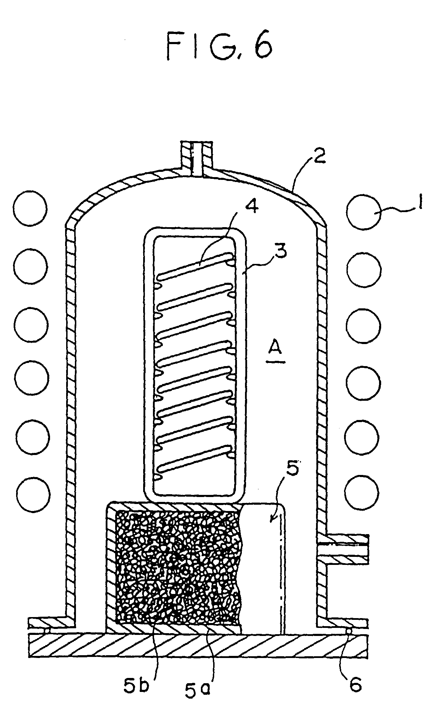

Conventionally, there is known a heat-treating apparatus which is constructed to house a wafer holder 3 in which wafers 4 are laminate-disposed within a furnace tube 2 made of silica glass surrounded by heating means 1, for example, as shown in Fig. 6, and which performs various heat treatment such as oxidation, diffusion, vapor phase depositing and annealing for the surface area of the wafers 4 while heating and controlling the wafers 4 placed on the wafer holder 3 to a predetermined temperature area by the foregoing heating means 1.

In this type of heat-treating apparatus, to save the installation area, a vertically-structured heat-treating apparatus furnace in which the foregoing furnace tube 2 is vertically installed, is mostly used. In such an apparatus, however, to prevent variation in the thickness of thin film to be formed or doped on the surface area of the wafers 4, and in the diffusate density distribution due to uneven temperature, a heat insulator 5 made of silica glass is provided between a heating area A in the furnace tube 2 and an open end side of the furnace tube 2 to make the space temperature for heat-treating the foregoing wafer 4 even. In addition, the heating means 1 surrounding the foregoing furnace tube 2 is located above the heat insulator 5 to cause the foregoing heat insulator 5 to function as a heat insulating material, whereby to prevent high temperature from propagating through 0-rings 6 provided on the open end side of the core tube 2 and other sealed portion.

In such an apparatus, the structure is arranged so that a wafer holder 3 is directly placed on the heat insulator 5. However, the heat insulator 5 is generally constructed by vacuum-sealing lint-shaped silica glass wool 5b within a sealed cylindrical body 5a made of silica glass, and therefore has low withstand load properties, thus imposing limitations on increased number and larger diameter of wafers.

Yet, since the top surface side of the foregoing heat insulator 5 is always exposed to high temperature because of radiant heat from heating means 1 surrounding the furnace tube 2 above it, if gas (air) remains in the sealed cylindrical body 5a or if pinholes communicating with outside air occur owing to cleaning or the like thereafter and the sealing is lost to allow cleaning liquid or outside air to enter, the residual gas (air), the entered air or the entered cleaning liquid within the cylindrical body is rapidly heated to further increase the internal pressure load by thermal expansion or expansion and vaporization, thus possibly rupturing and destroying the cylindrical body 5a.

To eliminate such defects, ribs, braces or other reinforcing bars have been provided within the foregoing cylindrical body 5a to increase the pressure strength. In recent years, however, as the diameter of the wafer 4 became larger, the core tube 2 became larger and the diameter of the foregoing heat insulator 5 also became larger which in turn reduced the pressure strength significantly. Accordingly, the foregoing reinforcing bars to be provided will have to be increased in geometric ratio, which will make the manufacturing operation of the heat insulator 5 more complicated, and greatly increase the manufacturing cost. In addition, particularly if the diameter of the foregoing heat insulator 5 is made as large as about 150 to 200 mm, it would be very difficult in the design and the manufacture to provide a large number of reinforcing bars so that the withstand pressure in a vacuum state and at high temperatures is fully satisfied, and as a result, a heat insulator 5 with such a large diameter could not be manufactured.

As a result, even when the furnace tube 2 is made larger with larger diameter of the wafer 4, the diameter of the foregoing heat insulator 5 cannot be made larger accordingly. Therefore, the heating temperature from the heat treating space for the wafer 4 within the furnace tube 2 dissipates through the void between the heat insulator 5 and the internal wall surface of the furnace tube 2 to fluctuate the heating temperature in the heat treating area A for the foregoing wafer 4, and at the same time, a problem develops in which propagation of high temperatures to the sealed portion on the open end side of the furnace tube 2 cannot be completely prevented.

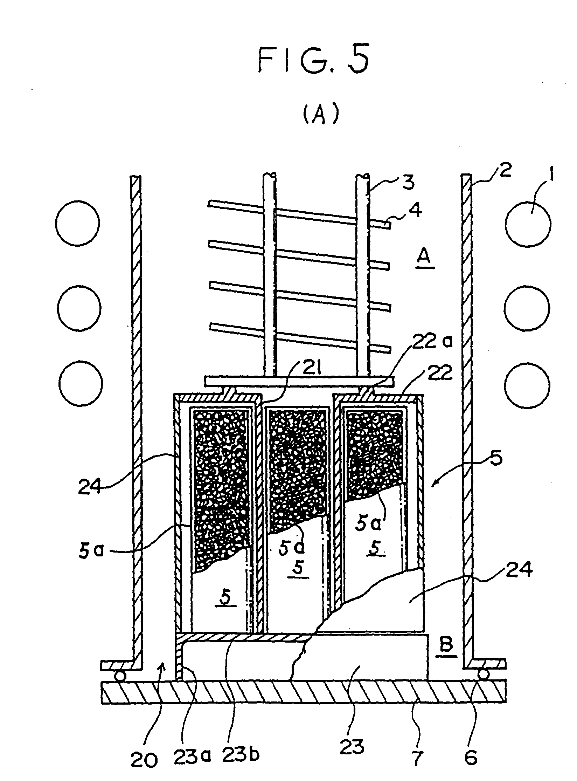

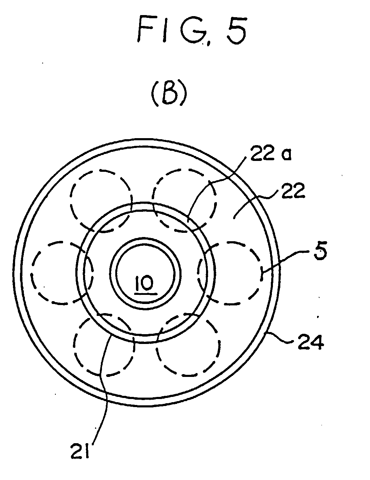

For this reason, the present inventors disclosed a technique in which, instead of placing a supporting boat 3 serving as a holder immediately on the foregoing heat insulator 5 as shown in Fig. 5, the foregoing heat insulator 5 is divided into a plurality of sub-cylindrical bodies 5a, a cylindrical frame body 7 for housing thus divided sub-cylindrical bodies 5a integrally is prepared, and the structure is arranged so that the foregoing supporting boat 3 is placed through the foregoing frame body 7 (Japanese Laid-Open Patent Application No. 62-203499).

In the foregoing apparatus, however, even if these are housed in the frame body 7, the sub-cylindrical bodies are constructed to be located within the furnace tube 2 in a ventilated state with the heating area on the side of the supporting boat 3 serving as a holder. Yet since the foregoing heat insulator 5 is divided into a plurality of sub-heat insulators with a smaller diameter, the function (heat retaining force and heat insulating force) of the heat insulating member itself, of which the inside is filled, is deteriorated, and the entire surface area becomes larger. In an apparatus or the like in which vapor phase growth is performed in a reduced pressure state like a CVD apparatus, for example, gas or particles adsorbed on the surface are scattered during the foregoing vacuum treatment, thus causing the treated substrate surface, such as a wafer, to be contaminated.

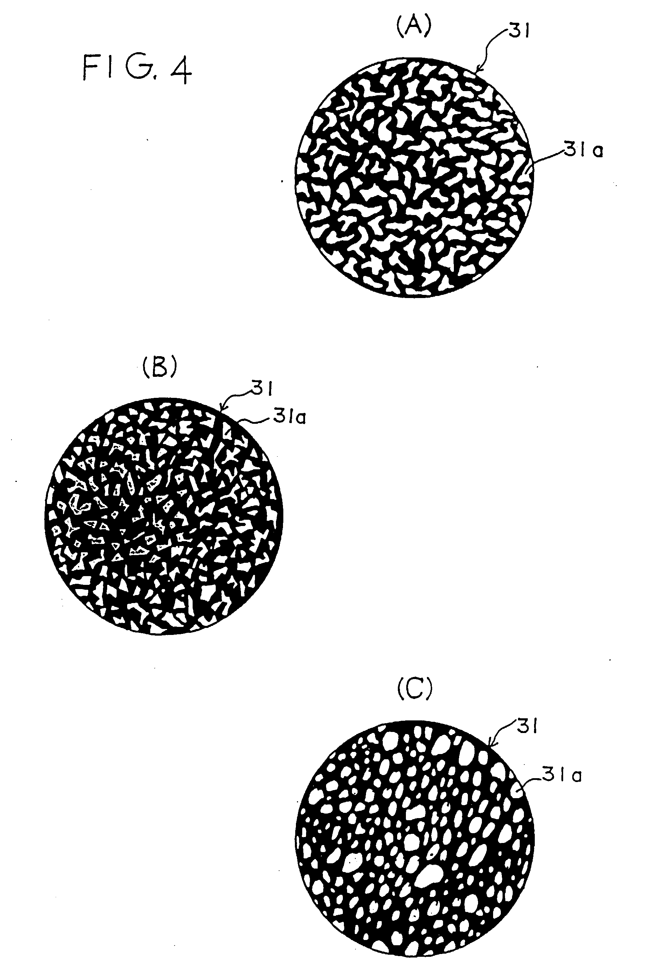

Also, in the foregoing apparatus, porous bodies 31 made of silica glass which have a large number of microspaces 31a inside, like sintered silica glass and foaming glass bodies as shown in Figs. 4 (A), (B) and (C), and which are hard, are used for the foregoing heat insulator 5 as a preferable embodiment. If, however, the heat insulator is used for the foregoing vacuum or reduced-pressure processing apparatus, a structure is preferable in which the surface side of the porous body 31 is covered with a transparent glass layer 32 to reduce the pressure and seal after the following porous body 31 is made vacuous to prevent rupture or damage. It is, however, quite difficult to evacuate a porous member existing as an isolated cell or an interconnected cell, and yet the larger the diameter of the foregoing heat insulating member 5 is, the more difficult the evacuation is, and it takes longer.

Besides, when the heat insulator 5 is constructed to be directly ventilated with a substrate processing area such as the wafer as mentioned above, a reaction film due to treated gas adheres to the surface of the heat insulating member. To remove the film, it is necessary to etch and clean the heat insulator 5 with hydrofluoric acid or the like after the foregoing heat treatment. When the foregoing glass layer is etched by etch-cleaning, the foregoing cleaning liquid may enter the inside of the air bubble.

A vertical heat-treating apparatus comprising the features of the first part of claim 1 is known from US-A-5 048 800.

### Summary of the Invention

In consideration of the defects of the prior art, the present invention has been designed, and it is an object of the invention to provide a vertical heat-treating apparatus having heat insulating and heat retaining properties which is capable of having a larger diameter for an increased number of wafers, and having high load and pressure strength properties, and a heat insulator to be favorably used particularly as a semiconductor, liquid crystal and TFT substrate heat-treating apparatus.

This object is met by a vertical heat treating apparatus according to claim 1. Preferred embodiments are disclosed in the depending claims.

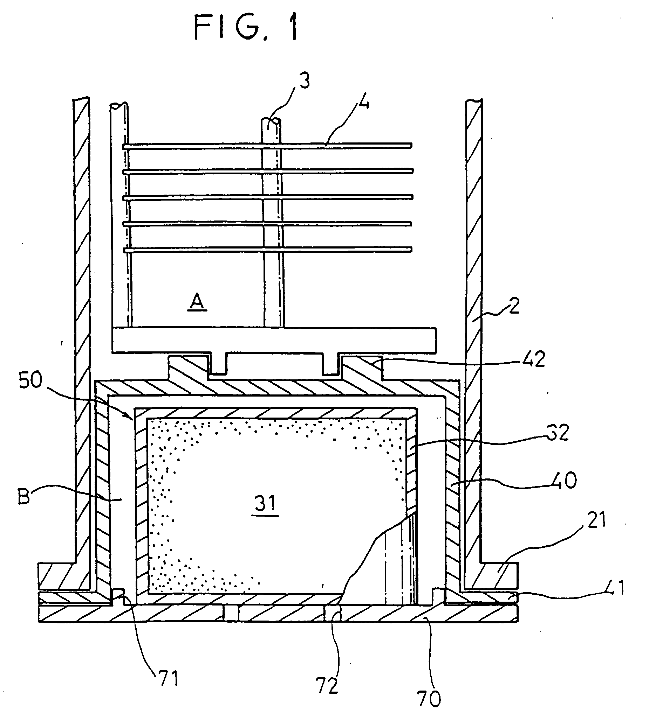

As shown in Figs. 1 to 3, a substrate holder 3 is provided on the top surface, a heat insulator casing 40 for housing a heat insulator 50 comprising the foregoing porous body is used in the lower space, and a heat insulator housing space B is airtightly separated from a substrate housing space A through the heat insulator casing 40. Further, the foregoing heat insulator housing space B is constructed so that it can be communicated with the outside or the pressure therein can be reduced or increased through a base 70 or a contact portion between a base 70 which supports the foregoing heat insulator casing 40 and a heat insulator casing flange 41.

Moreover, the structure is preferably arranged so that the foregoing heat insulator 50 and the heat insulator casing 40 are concentrically disposed with respect to the furnace tube 2 respectively, and the back surface side of the substrate supporting portion of the foregoing heat insulator casing 40 can be supported on the top surface side of the foregoing heat insulator 50.

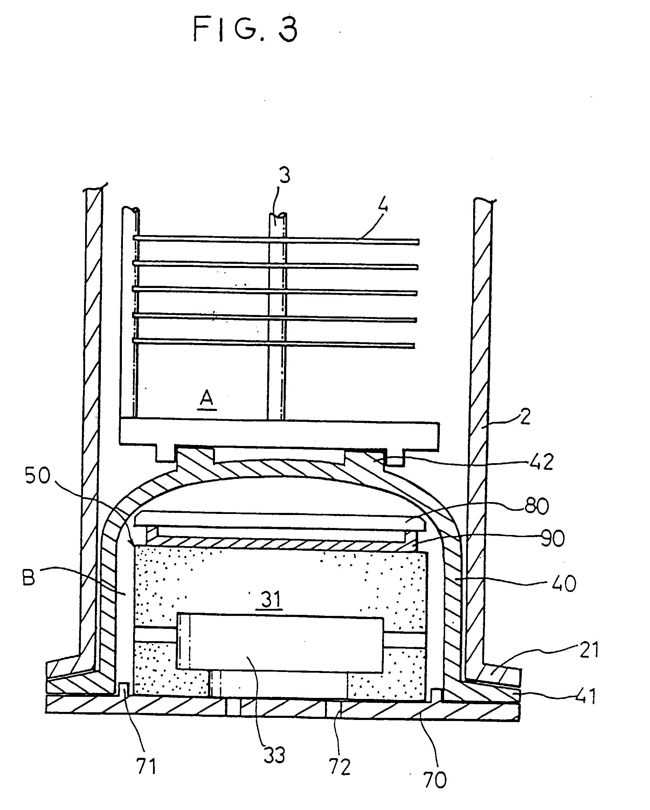

Moreover, any member 80 being a frosted silica glass member, a silica porous member having an apparent density of 0.9 g/cm³ or higher, a SiC member, a silicon nitride member, a polycrystalline or single-crystalline silicon member, or an alumina member, is preferably disposed at a point where the foregoing heat insulator 50 has a cavity capable of communicating with the heat insulator housing space B of the heat insulator casing 40 inside, as shown in Fig. 3, and/or in a space between the foregoing heat insulator 50 and the heat insulator casing 40.

According to the invention, since the heat insulator housing space B and the substrate holder housing space A are airtightly separated through the heat insulator casing 40, and the heat insulator housing space B side is maintained in a state of communicated with the outside, it is possible to always maintain the heat insulator housing space B at the usual operating pressure, thus making it unnecessary to evacuate the porous member 31 for forming the heat insulator 50. Since it can be formed at the usual operating pressure, it becomes easy to make the diameter of the heat insulator 50 larger.

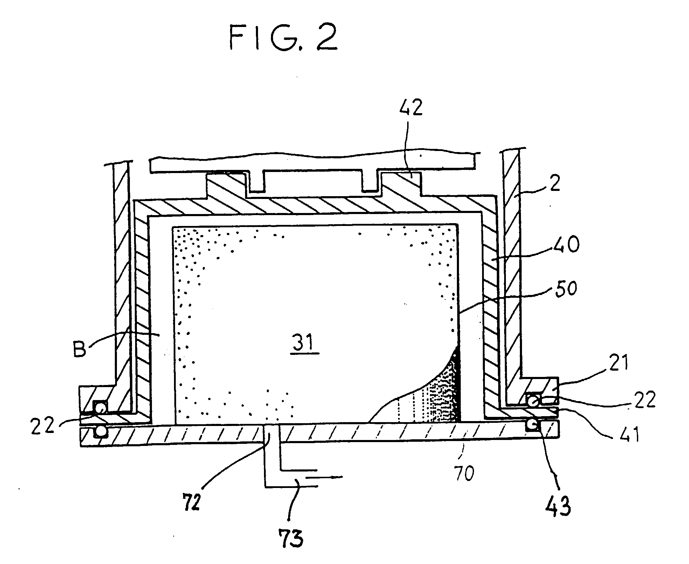

Also, even in an apparatus for performing vapor phase depositing or oxidation or diffusion in a pressure-reduced state or a pressurised state, like a pressure reducing vapor phase depositing apparatus shown in Fig. 2 or a high-pressure oxidation or diffusion apparatus, the pressure in the foregoing housing space B may be reduced or increased to nearly the same pressure as on the substrate holder housing space A side through a vent hole in the base. In this case, since the heat insulator is composed of a silica glass porous member instead of wool material, there is no possibility that the ventilation piping system is clogged up by sucking up wool dust. Also, since each of the housing spaces is maintained nearly at the same pressure in a sealed portion 22, a precision seal such as an 0-ring is not always required, but a sealing method such as fitting may be used.

When the diameter of the heat insulator casing 40 for mounting the holder 3 is made larger to meet the furnace tube 2 as mentioned above, the holder load properties of the heat insulator casing 40 are reduced significantly. Since, however, the heat insulator 50 according to the present invention is composed of the silica glass porous member having a significant load strength itself, the heat insulator 50 and the heat insulator casing 40 are concentrically disposed with respect to the core tube respectively, and the structure is arranged so that the back surface side of the substrate supporting portion of the heat insulator casing 40 can be supported on the top surface side of the heat insulator 50. Thereby, even when the diameter of the heat insulator casing 40 is made larger, the load strength properties are not reduced, and even when a large number of substrates are mounted on the holder 3, it can be fully coped with.

Further, since the heat insulator 50 and the heat insulator casing 40 are separately formed, it is also easy to form the top portion substantially convexly or concavely like the heat insulator casing 40 in Fig. 3, whereby it becomes possible to provide the heat insulator casing 40 with sufficient load and pressure strength performance even if the pressure in the heat insulator housing space B is reduced or increased.

Also, since the heat insulator 50 is not exposed to the treating gas, only the heat insulator casing 40, to which a film adheres, requires cleaning. Further, also SiC, silicon nitride or silicon members, which have conventionally been regarded as difficult to be cleaned, can be used together with the heat insulator 50 made of silica glass like a silicon disc member 80.

Thus, the penetration of impurities such as Cu, Na and Fe, for example, which easily penetrate silica glass from the oven inlet side, can be prevented by the use of SiC, silicon nitride, a silicon member or an alumina member, which has high density and high diffusion, transmission and barrier properties. Additionally, also the temperature evenness can be improved by preventing the heat within the oven due to light in the diameter direction of the oven from dissipating by use of a thin sheet made of SiC, silicon nitride, silicon member, or alumina member, which has comparatively high heat conductivity and low light transmission properties.

As a result of the latter glare protection an even temperature can be attained even by use of a frosted silica glass member or a silica porous member having an apparent density of 0.9 g/cm³ or higher (higher density than the porous member) for example. Particularly, the frosted silica glass member is capable of maintaining the stable effect because a portion frosted by cleaning can be prevented from becoming transparent.

Particularly, SiC, silicon nitride, polycrystalline or single-crystalline silicon member, or alumina member is capable of easily maintaining the heat retaining effect of the substrate holder housing space A side, and the temperature evenness in the radial direction because it has higher heat absorption and heat barrier properties than silica glass.

With the provision of a cavity capable of communicating with the heat insulator housing space of the heat insulator casing 40 in the heat insulator 50 inside, the thermal capacity can be reduced without impairing the heat-shield heat retaining properties.

A structure which is favorably used as the foregoing heat insulator 50, is the silica glass porous body 31 composed of silica glass foam having air-bubbles at an apparent density of 0.1 to 0.8 g/cm³, and containing Na, K, Li, Cu, Ni, Ca and Ce of 1 ppm or less respectively, metallic impurities of a grand total amount of 100 ppm or less, and radical OH of 100 ppm or less, although the heat insulator is formed with a porous body 31 made of silica glass having a large number of microspaces 31a inside as shown in Fig. 4 in the same way as in the foregoing prior art.

In this connection, to produce the foregoing silica glass foam, fine silica glass powder is first obtained by heat-treating high-purity synthetic silica glass powder by thermal vapour-phase reaction containing 1 ppm or less of each of the foregoing metallic impurities which result in semiconductor degradation with an ammonia gas atmosphere at 800°C. Then, a heat-resistant crucible is filled with the obtained fine silica glass powder, and is heated at 1,700°C in an atmosphere under reduced pressure to cause fusing and foaming the fine silica glass powder.

In consequence small thermal capacity and excellent heat-shielding properties are obtained, and yet any occurrence of gas during heating due to moisture absorption can be prevented. Further, silica glass foam for constituting the heat insulator 50 is amorphous. The grand total amount of metallic impurities such as Na, K, Li, Al, Ni, Cu, Ca, Fe and Ce, for example, which promote the crystallization of silica glass, is 100 ppm or less, and particularly the content of elements of Na, Li, Cu, Ni and Ca, which quickly move and easily contribute to the crystallization, is 1 ppm or less, respectively. In addition, the OH group content is 100 ppm or less to maintain the heat resistance. Thus, even if the apparatus is repeatedly heated at high temperatures (600°C to 1,300°C), no deformation nor cracking will occur any longer, thus enabling the apparatus to be used for a long term.

Particularly since silica glass has a higher thermal coefficient of expansion by crystallization, the crystallization is likely to cause cracking or destroy the silica glass by heat shock due to rapid temperature rise. It is important that the whole should be amorphous, and high purity should be kept from the beginning.

### Brief Description of the Drawings

Figs. 1, 2 and 3 are principal portion front sectional views showing the principal portion structure of a vertical heat-treating apparatus according to an embodiment of the present invention respectively;
Fig. 4 is an enlarged view showing an inner structure of a porous member applied to a head insulator;
Figs. 5A and 5B show the principal portion structure of a vertical heat-treating apparatus according to a prior art, wherein Fig. 5A is a front sectional view, and Fig. 5B is a plan view showing the top surface side of a heat insulator;
Fig. 6 is an overall front sectional view showing a conventional heat-treating apparatus.

### Preferred embodiment of the Invention

Fig. 1 shows the principal portion structure of a vertical heat-treating apparatus according to a first embodiment of the present invention, and the lower portion of a furnace tube 2 in which a heat insulator 50 is arranged.

A reference numeral 2 designates a cylindrical dome-shaped vertical furnace tube, in which a flange 21 is provided at the opening on the lower end side. The vertical core tube is airtightly structured so that the flange 21 can be installed on the top surface of the flange 41 on heat insulator casing 40 side.

The outer surface of the heat insulator casing 40 having an outer diameter slightly smaller than the inner diameter of the foregoing furnace tube 2 is made of transparent silica glass frosted by sandblast, and the top surface thereof is so planar that a substrate holder 3 can be mounted thereon. The flange 41 provided at the opening on the lower end side is formed to have the same diameter as that of the flange 21 on the furnace tube 2 side. On the foregoing planar top surface, ring bodies 42 are projectingly provided, and the holder 3 is structured so that it can be positioned and mounted on the ring bodies 42.

A base 70 is structured so that it forms a circular plate with the same diameter as the outer diameter of the foregoing flange 41, and the peripheral surface of the base 70 can be installed on the lower surface side of the flange 41 of the heat insulator casing 40.

The base 70 is structured so that a ring body 71 is projectingly provided concentrically on the top surface side in proximity to the inner wall surface of the heat insulator casing 40 to position and install the heat insulator 50 on the ring body 71, and that a through-hole 72 is provided at the central portion of the base 70 to be ventilated with the outside.

As a result, since the heat insulator housing space B between the heat insulator casing 40 and the base 70 can be ventilated, and the furnace tube 2 is airtightly provided on the top surface side of the heat insulator casing 40, the substrate holder housing space A within the furnace tube 2 and the foregoing heat insulator housing space B are airtightly separated.

The heat insulator 50 to be provided on the base 70 is formed of a porous member 31 comprising a silica glass foam, and a surrounding body 32 made of transparent silica glass which surrounds the circumference thereof. The silica glass foam has a large number of micro-air bubbles inside with a communicating air-bubble ratio of 20% (volume ratio) at apparent density of 0.3 g/cm³, and contains Na, K, Li, Al, Ni, Cu, Ca, Fe and Ce having a density of 1 ppm or less each, and OH group content at 10 ppm or less.

The manufacturing procedure of the foregoing porous member 31 will be described hereafter. First, fine silica glass powder is obtained by heat-treating high-purity synthetic silica glass powder by thermal vapour-phase reaction containing almost all metallic impurities of 1 ppm or less each within ammonia gas atmosphere at 800°C beforehand. Then, a crucible made of carbon having a somewhat larger diameter than a surrounding body 32 opened upwardly, and excessively high for the diameter is filled with thus obtained fine silica glass powder, and is heated at 1,700°C in an atmosphere under reduced pressure to cause fusing and foaming the fine silica glass powder, thus obtaining the silica glass foam which is somewhat larger than the surrounding body 32 and contains microspaces inside.

By burning the surface of the thus obtained foam by an oxygen-hydrogen gas burner to fuse and clarify, a so-called foamed glass-shaped porous member 31, formed of the surrounding body 32 made of transparent silica glass, inside of which a thin film of silica glass is spread vertically and horizontally, is formed.

From the weight and the apparent volume of the obtained foamed glass-shaped porous member 31, the apparent density was determined. From the apparent density and an increase of weight when immersed in liquid, the communicating porosity (volume ratio) for the inside total microspace was determined. Further, the density of each of the metallic impurities was investigated by using the ICP method analysis, and the content of OH group content was investigated by the diffuse reflection spectral method using FT-IR.

As another manufacturing process different from the present embodiment, instead of heat-treating using ammonia gas, a foaming agent, which is gasified by reacting and decomposing at high temperatures like carbon and an oxidizer or metallic carbonate, can be mixed with fine silica glass powder, and be causing fusing and foaming at high temperatures to obtain a similar foam. Since the foam easily remains in the porous member 31, and is gasified during use or crystallization of the porous body 31 is promoted, an expanding method using ammonia gas is preferable.

In this connection, in the present embodiment, since the heat insulator housing space B is airtightly separated from the substrate holder housing space A, it is also possible to utilise the porous member 31 taken out from the crucible as it is as the heat insulator 50. However, it may be possible to locate, for example, a silica sintered body or silica glass frame inside the crucible, and causing fusing and foaming to form a silica sintered of silica glass layer.

Since the heat insulator 50 including the porous member itself has withstand load strength, and has further a thick-walled surrounding body on its surface, it is also possible to set the back surface thereof to substantially the same height as that of the foregoing housing space and structure so that the back surface side of the installed surface of the substrate holder of the heat insulator casing 40 can be supported on the top surface of the heat insulator 50.

The heat insulator 50 structured in this way was incorporated in the apparatus shown in Fig. 1 of the present embodiment, and a rise and fall of temperature at 30°C/min was repeated about 400 times between normal temperatures and 1,200°C to observe a state of the formed porous body 31. As a result, no deformation nor cracking were found at all, but it was proved that it has excellent durability.

Then, when the porous body 31 of the above embodiment 1 was foamed, there was used fine silica glass powder obtained by heat-treating natural silica glass fine powder with lower purity than in the embodiment 1 in ammonia gas atmosphere at 800°C. Thus, there was obtained a low-purity porous body 31 comprising silica glass foam having continuous porosity of 30% (volume ratio) at apparent bulk density of 0.3 g/cm³, and containing Na, K, Li, Ca, Ni, and Fe having density of about 2 ppm each, Al having density of about 50 ppm, Ce and Cu having density of 1 ppm or less each, and OH group content at 10 ppm or less.

The porous body 31 thus obtained was incorporated in the apparatus shown in Fig. 1 in the same manner as in the embodiment 1, which is regarded as a relative example 1. In the same manner as in the embodiment 1, rise and fall of temperature at 30°C/min were repeated about 400 times between normal temperatures and 1,200°C to observe a state of the foregoing porous member 31. As a result, at about the 200th repetition, dusting due to a large number of microcracks and peeling was observed on the surrounding body surface, and at about the 400th repetition, the porous member was crazed, and the vent hole was observed to be clogged with peeled substances.

Moreover, high-purity synthetic silica glass fine powder similar to the embodiment 1 was added with a trace quantity of potassium oxide, calcium carbonate and carbon of 0.4 wt.% as an expanding agent for mixing by means of a ball mill made of alumina. Then, it was heated at 1,700°C in an atmosphere under reduced pressure, and the fine silica glass powder was fused and foamed. Besides, by treating it in the same way as in the embodiment 1, there was obtained a porous body 31 comprising silica glass foam having continuous porosity of 70% (volume ratio) at apparent density of 0.4 g/cm³, and containing Na, K, Li, Ni, and Fe having a density of about 1 ppm or less each, Al having a density of about 100 ppm, Ca and Ce having a density of 8 ppm each, and a OH group content of about 140 ppm.

The porous body 31 thus obtained was incorporated in the apparatus shown in Fig. 1 in the same manner as in the embodiment 1, which is regarded as a relative example 2. In the same way as in the embodiment 1, rise and fall of temperature at 30°C/min were repeated about 200 times between normal temperatures and 1,200°C to observe a state of the foregoing porous body 31. As a result, at about the 200th repetition, a large number of microcracks, crazing and peeled substances were observed on the same surface as in the embodiment 2, and at about the 400th repetition, collapse partly occurred in the porous member due to advances in large craze and reticulate cracking. Also, the foregoing porous body after the repeated test had thermal deformation, and shrinkage of about 30% in volume was found.

After the repeated tests of these relative examples 1 and 2, a part of the porous body was peeled off to investigate it by using the X-ray diffractometry, and crystalline cristobalite was detected. Thus, it turned out that the deteriorated durability is inversely affected by the crystallization.

Fig. 2 shows the embodiment 2 in which the structure is applied to a vapor phase depositing apparatus. The difference between the embodiment 2 and the foregoing embodiment 1 will be mainly described. A vacuum piping system 73 is connected to a vent hole 72 in the base 70, 0-rings 22 and 43 are interposed between flanges 21 and 41 provided on the lower end side of the furnace tube 2 and the heat insulator casing 40 respectively and the base 70 respectively so that the pressure in the substrate housing space A and that in the heat insulator housing space B can be both reduced or reduced and maintained.

Also, when the pressure in the foregoing housing space B is reduced through the vent hole 72 in the base 70 at this juncture, there is no possibility that the vacuum piping system 73 sucks up wool dust or peeled substances to be clogged because the heat insulator 50 is made of the foregoing high-purity silica glass porous body instead of wool.

Fig. 3 shows an embodiment 3 in which the structure is applied to high-pressure oxidation, and its differences from the foregoing embodiments 1 and 2 will be mainly described. Like the embodiment 1, at the central portion of the base 70, a through-hole 72 is provided so that ventilation with the outside can be performed. Taper fitting at about 5° is provided between flanges 21 and 41 which are provided on the lower end side of the furnace tube 2 and the heat insulator casing 40 so that the internal pressure within the substrate housing space A does not escape to the outside.

Also, on the top surface of the heat insulator casing 40, there is provided a ring body 42 so that the substrate holder 3 can be mounted thereon, and the top surface is structured to be so convex dome-shaped as a whole that it can withstand the treated gas pressure in the holder housing space A.

Also, in the heat insulator housing space B between the foregoing heat insulator casing 40 and the heat insulator 50, there is placed a silicon disc member 80 on the heat insulator 50 through a leg base 90 made of silica glass, whereby to improve the temperature evenness at the oven inlet in the diameter direction.

Also, within the foregoing heat insulator 50, there is provided a cavity 33 capable of communicating with the heat insulator housing space B in the heat insulator casing 40, whereby the heat capacity can be reduced without impairing the heat-shield heat retaining properties, thus improving the temperature controllability of the furnace tube 2.

As mentioned above, the first embodiment of the present invention is favorably applicable to processing apparatus under reduced pressure or under pressure in vapor phase depositing high-pressure oxidation or the like which is capable of maintaining the durability even at repeated rise and fall in temperature for a long term while sufficiently satisfying the heat-shield, the heat-retaining and the withstand thermal load and withstand pressure properties which are enough to withstand larger diameter and increased number of the substrates.

Also, according to the second embodiment of the invention, it is possible to obtain a heat insulator capable of being used stably over a long period of time without causing any microcracks, crazing and peeled substitutes, and without causing any collapse due to advance of the cracks even if heat treatment and cooling are repeated many times. The second embodiment of the invention is applicable to the first embodiment as well as the apparatus shown in Figs. 5 and 6.

## Claims

1. A vertical heat-treating apparatus comprising a heat insulator (50), a heat insulator casing (40) accommodating said heat insulator (50) in a lower space, and a work holder (3) disposed on top of said heat insulator casing (40), for which apparatus said heat insulator casing (40) defines a heat insulator accommodation space (B) accommodating said heat insulator (50) and a work holder accommodation space (A) accommodating said work holder (3),
**characterised in** that
said heat insulator (50) is constituted by a porous body of silica glass (31) having numerous inner microspaces (31a), said two accommodation spaces (A, B) are airtightly separated from each other and said heat insulator accommodation space (B) is communicated with the outside or is capable of pressure reduction and increase.

2. The apparatus according to claim 1, wherein said heat insulator (50) and said heat insulator casing (40) are arranged concentrically with respect to a furnace core tube (2), the back surface of the portion of said heat insulator casing (40) supporting said work holder (3) being capable of being supported on top of said heat insulator (50).

3. The apparatus according to claim 1 or 2, wherein said heat insulator (50) has a cavity (33) capable of being communicated with said heat insulator accommodation space (B).

4. The apparatus according to any of claims 1 to 3, further comprising a member selected from the group consisting of frosted quartz glass, porous quartz having an apparent density of 0.9 g/cm³ or over, SiC, silicon nitride, silicon and alumina, said member being disposed between said heat insulator (50) and said heat insulator casing (40) and/or in said cavity (33).

5. The apparatus according to any of claims 1 to 4, wherein said heat insulator (50) is constituted by a quartz glass foam having an apparent density of 0.1 to 0.8 g/cm³, concentrations of Na, K, Li, Cu, Ni, Ca and Ce each of 1 ppm or below, a total concentration of metallic impurities of a grand total amount of 100 ppm or below and an OH group content of 100 ppm or below.

6. The apparatus according to claim 5, wherein said quartz glass foam containing microspaces is obtained by preparing silica glass powder through heat treating of high-purity synthetic silica glass powder by thermal vapour-phase reaction containing 1 ppm or below of each of said metallic impurities in an ammonia gas atmosphere at 800° C, and fusing and foaming said silica glass powder in a heat-resistant crucible in a reduced pressure atmosphere at 1,700° C.

## Patentansprüche

1. Vertikale Wärmebehandlungsvorrichtung mit einem Wärmeisolierstoff (50), einem Wärmeisolierstoffgehäuse (40) zum Aufnehmen des Wärmeisolierstoffs (50) in einem unteren Bereich und einem auf dem Wärmeisolierstoffgehäuse (40) angeordneten Werkstückaufnehmer (3), wobei das Wärmeisolierstoffgehäuse (40) für die Vorrichtung, einen Wärmeisolierstoff-Aufnahmebereich (B) zum Aufnehmen des Wärmeisolierstoffs (50) und einen Werkstückaufnehmer-Aufnahmebereich (4) zum Aufnehmen des Werkstückaufnehmers (3) festlegt,
**dadurch gekennzeichnet,** daß
der Wärmeisolierstoff (50) aus einem porösen Körper aus Quarzglas (31) mit einer Vielzahl innerer Mikro-Räumen (31a) besteht, wobei die zwei Aufnahmebereiche (A, B) voneinander luftdicht getrennt sind und der Wärmeisolierstoff-Aufnahmebereich (B) mit dem Außenraum in Verbindung steht oder zur Druckreduzierung oder -erhöhung geeignet ist.

2. Vorrichtung gemäß Anspruch 1, wobei der Wärmeisolierstoff (50) und das Wärmeisolierstoffgehäuse (40) konzentrisch in bezug auf eine Ofen-Kernröhre (2) angeordnet sind, wobei die Rückseite des Bereiches des Wärmeisolierstoffgehäuses (40), das den Werkstückaufnehmer (3) trägt, ausgelegt ist, um auf dem Wärmeisolierstoff (50) abgestützt zu werden.

3. Vorrichtung gemäß Anspruch 1 oder 2, wobei der Wärmeisolierstoff (50) einen Hohlraum (33) aufweist, der ausgelegt ist, um mit dem Wärmeisolierstoff-Aufnahmebereich (B) in Verbindung zu stehen.

4. Vorrichtung gemäß einem der Ansprüche 1 bis 3, weiter aufweisend ein Element aus der Gruppe mattiertes Quarzglas, poröser Quarz mit einer Fülldichte von 0,9 g/cm³ oder mehr, SiC, Siliciumnitrat, Silicium oder Aluminium, wobei das Element zwischen dem Wärmeisolierstoff (50) und dem Wärmeisolierstoffgehäuse (40) und/oder im Hohlraum (33) angeordnet ist.

5. Vorrichtung gemäß einem der Ansprüche 1 bis 4, wobei der Wärmeisolierstoff (50) aus einem Quarzglasschaum mit einer Fülldichte von 0,1 bis 0,8 g/cm³, einer Konzentration von Na, K, Li, Cu, Ni, Ca und Ce von jeweils 1 ppm oder weniger, einer Gesamtkonzentration an Metallverunreinigungen bezogen auf die Gesamtsumme von 100 ppm oder weniger und einem OH-Gruppen-Gehalt von 100 ppm oder weniger besteht.

6. Vorrichtung gemäß Anspruch 5, wobei der die Mikro-Räume enthaltende Quarzglasschaum durch Verarbeiten von Quarzpulver mittels Wärmebehandeln von hochreinem, synthetischem Quarzglaspulver durch thermische Gasphasen-Reaktion mit 1 ppm oder weniger von jeder Metallverunreinigung in einer Ammoniakgas-Atmosphäre bei 800° C und Schmelzen und Schäumen des Quarzglaspulvers in einem hitzebeständigen Schmelztiegel in einer Atmosphäre mit reduziertem Druck bei 1,700° C erhalten wird.

## Revendications

1. Appareil de traitement thermique à disposition verticale constitué par un isolant thermique (50), un carter de l'isolant thermique (40) contenant ledit isolant thermique (50) dans un espace inférieur et un support de travail (3) situé au sommet dudit carter de l'isolant thermique (40), ledit carter de l'isolant thermique (40) de l'appareil définissant un espace (B) de l'isolant thermique contenant ledit isolant thermique (50) et un espace (A) du support de travail contenant ledit support de travail (3),
caractérisé en ce que
ledit isolant thermique (50) est constitué par un corps poreux en verre de silice (31) ayant de nombreux micro-espaces intérieurs (31a), les deux espaces constituant des logements (A,B) susdits sont séparés de façon étanche l'un de l'autre et ledit espace contenant l'isolant thermique (B) est en communication avec l'extérieur et sa pression peut être diminuée et augmentée.

2. Appareil selon la revendication 1, dans lequel ledit isolant thermique (50) et ledit carter de l'isolant thermique (40) sont disposés de façon concentrique par rapport à un tube canal de four (2), la surface inférieure de la partie dudit carter de l'isolant thermique (40) supportant ledit support de travail (6) pouvant être supportée par le sommet dudit isolateur thermique (50).

3. Appareil selon la revendication 1 ou 2, dans lequel ledit isolant thermique (50) a une cavité (33) capable d'être mise en communication avec ledit espace contenant l'isolant thermique (B).

4. Appareil selon une quelconque des revendications 1 à 3, comprenant en outre un élément choisi dans le groupe constitué par le verre de quartz dépoli, le quartz poreux ayant une masse volumique apparente de 0,9 g/cm³ ou plus, SiC, le nitrure de silicium, le silicium et l'alumine, ledit élément étant disposé entre ledit isolant thermique (50) et ledit carter de l'isolant thermique (40) et/ou dans ladite cavité (33).

5. Appareil selon une quelconque des revendications 1 à 4, dans lequel ledit isolant thermique (50) est constitué par de la mousse de verre de quartz ayant une masse volumique apparente de 0,1 à 0,8 g/cm³, des concentrations en Na, K, Li, Cu, Ni, Ca et Ce égales ou inférieures chacune à 1 ppm, une concentration totale en impuretés métalliques d'une valeur totale de 100 ppm ou moins et une teneur en groupes OH de 100 ppm ou moins.

6. Appareil selon la revendication 5, dans lequel ladite mousse de verre de quartz contenant des micro-espaces est obtenue par préparation de poudre de verre de silice par traitement thermique d'une poudre de verre de silice de synthèse de haute pureté par une réaction thermique en phase vapeur contenant 1 ppm ou moins de chacune desdites impuretés métalliques dans une atmosphère d'ammoniac gazeux à 800°C, et par la fusion et l'expansion de ladite poudre de verre de silice dans un creuset réfractaire sous pression réduite à 1 700°C.
